# EUROPÄISCHE PATENTANMELDUNG

(11) **EP 0 593 869 A1**
(43) Veröffentlichungstag der Anmeldung: **27.04.1994**
(21) Anmeldenummer: 93113039.7
(22) Anmeldetag: 14.08.1993
(51) Int. Cl.: H01M 10/44, G01R 31/36, H02J 7/00

(54) **Wiederaufladbarer Akku**

(30) Priorität: 10.10.1992 DE 4234231
(71) Anmelder: Adolf Würth GmbH & Co. KG, D-74653 Künzelsau (DE)
(72) Erfinder: Schulz, Juergen, D-3572 Amoeneburg (DE); Hofacker, Bernd, D-7118 Kuenzelsau (DE)
(74) Vertreter: Patentanwälte Ruff, Beier, Schöndorf und Mütschele

(57) **Zusammenfassung**

Am Ende eines Entladevorgangs eines Akkumulators weist dieser eine erhöhte Innentemperatur auf. Um ihn wieder aufladen zu können, muß gewartet werden, bis er sich abgekühlt hat. Die Ladezeit wird also wesentlich durch die Abkühlzeit bestimmt. Zur Verkürzung der Ladezeit schlägt die Erfindung vor, in den Akkumulator einen Temperaturfühler einzubauen und bei Erreichen einer vorbestimmten Temperatur den Akku abzuschalten. Er liefert dann keinen Strom mehr, obwohl er noch nicht leer ist. Er läßt sich dann aber sofort wieder aufladen, so daß die Abkühlzeit entfällt. Trotz der kürzeren Entladedauer steht der Akku also über einen größeren Zeitraum zur Verfügung.

## Beschreibung

Die Erfindung betrifft einen wiederaufladbaren Akku für elektrisch betriebene Geräte.

Zu den elektrisch betriebenen Geräten, die z.Z. mit Akkumulatoren betrieben werden, gehören insbesondere Elektrowerkzeuge. Gerade beim Montagebetrieb ist die Verwendung eines akku-betriebenen Werkzeugs vorteilhaft, da keine Verlängerungskabel verwendet werden müssen und die Gefahr einer Beschädigung des Kabels durch das Werkzeug selbst wegfällt.

Bei diesen Werkzeugen sind die Akkumulatoren zu Akkupacks zusammengefaßt, die sich einfach an das Werkzeug anstecken lassen. Wenn der Akku leer ist, wird er gegen einen zweiten vollen Akku ausgetauscht. Der jetzt leere Akku kann in ein Ladegerät eingesetzt werden. Um nun die Zeit, nach der der leere Akku wieder zur Verfügung steht, zu verkürzen, sind Schnellladegeräte vorgeschlagen worden, die einen Akku in kurzer Zeit wieder aufladen können. Ideal wäre es, wenn die Ladezeit so lang wäre wie die Benutzungsdauer des Akkus mit einer Ladung.

Es ist bekannt, daß das Aufladen eines Akkus von seiner Temperatur abhängt. Ist ein Akku zu warm, so sinkt die in ihm speicherbare Stromkapazität. Aus diesem Grunde enthalten die auf dem Markt befindlichen Ladegeräte eine Temperaturautomatik, die ein Aufladen des Akkus verhindern, so lange dieser noch wärmer als etwa 45° C ist. Zu der eigentlichen Aufladezeit des Ladegerätes kommt dann noch die Abkühlzeit des Akkus hinzu, die wesentlich länger als die eingentliche Aufladezeit ist. Der Vorteil einer an sich möglichen Schnellaufladung geht dadurch wieder verloren.

Der Erfindung liegt die Aufgabe zugrunde, eine Möglichkeit zu schaffen, die Wiederaufladezeit eines Akkumulators so zu verkürzen, daß ein Benutzer im Dauerbetrieb mit zwei Akkus auskommt, die im Wechselbetrieb das elektrische Gerät antreiben.

Zur Lösung dieser Aufgabe schlägt die Erfindung einen Akku mit den Merkmalen des Anspruchs 1 vor. Weiterbildungen sind Gegenstand der Unteransprüche.

Die Erfindung basiert auf der Erkenntnis, daß gegen Ende der Entladung des Akkus im Elektrogerät die Temperatur des Akkus steigt. Statt nun die Kapazität des Akkumulators vollständig auszunutzen, unterbricht die Erfindung die Stromabgabe des Akkumulators vor dessen Tiefentladung. Der dadurch in Kauf genommene scheinbare Nachteil einer um etwa 5% geringeren Entladedauer wird dadurch mehr als wett gemacht, daß der Akkumulator zu diesem Zeitpunkt eine Temperatur aufweist, die sein sofortiges Nachladen, auch Schnelladen; zuläßt. Es wird dadurch möglich, den Akku während der Zeit nachzuladen, während der der zweite Akku das Elektrogerät betreibt. Es ist auch möglich, den Akku in einem speziell dafür konstruierten Ladegerät zu laden, das einen höheren Ladestrom verwendet.

Sollte der Akku einmal mit großeren Pausen betrieben werden, so wird die Auslösetemperatur erst zu einem Zeitpunkt erreicht, zu dem der Akku stärker entladen ist. Auch hier kann dann die Nachladung sofort geschehen. Ein scheinbarer Nachteil wird also von der Erfindung in einen Vorteil verwandelt.

Die Auslösetemperatur, bei der der Akkumulator abgeschaltet wird, kann nach den Umständen des Einzelfalls verändert werden. Insbesondere ist es aber möglich, die Abschalttemperatur höher anzusetzen als die bislang übliche Temperatur von 45° Grad, oberhalb der die handelsüblichen Ladegeräte nicht laden. Denn während des gesamten Ladevorgangs verringert sich aufgrund des Ladevorgangs die Temperatur etwas. Unterstützt werden kann dies durch eine Kühleinrichtung im Ladegerät, beispielsweise einen Ventilator.

Erfindungsgemäß kann vorgesehen sein, daß die Schalteinrichtung zum Unterbrechen der Verbindung einen Bimetallschalter aufweist. Dieser Bimetallschalter enthält damit auch schon den Temperaturfühler.

In Weiterbildung der Erfindung kann vorgesehen sein, daß der Akku eine elektronische Schaltung aufweist, die einen Schalter zum Unterbrechen der Verbindung enthält und/oder ansteuert. Der Temperaturfühler kann ebenfalls Teil der elektronischen Schaltung sein, beispielsweise ein Widerstand mit temperaturabhängigem Widerstandswert.

Der Schalter kann beispielsweis ein elektronischer Schalter sein, also beispielsweise ein Schalttransistor. Insbesondere wird von der Erfindung jedoch vorgeschlagen, daß der Schalter von einem Relais gebildet wird. Dieses Relais stellt im Ruhezustand, d. h. ohne Ansteuerung, die Verbindung zwischen Akku und Kontakt des Akkus her. Erst wenn die Auslösetemperatur überschritten wird, wird das Relais betätigt und öffnet den Schalter. Dies bedeutet auch, daß der Stromverbrauch für die zusätzlich erforderliche Schalteinrichtung niedrig ist.

Anstelle des Relais kann auch ein Thyristor, ein Transistor oder ein Triac verwendet werden.

Die von der Erfindung vorgeschlagene Möglichkeit soll insbesondere bei elektrischen Werkzeugen anwendbar sein. Hier tritt gerade der Fall auf, daß das Werkzeug im Dauerbetrieb benutzt wird, ggf. unterbrochen von kurzen Pausen. Als Beispiel sei das Einschrauben von Schrauben oder das Bohren von Löchern genannt. Hier tritt jeweils nach dem Herstellen eines Loches oder nach dem Eindrehen einer Schraube eine Arbeitsunterbrechung ein, bevor der nächste Arbeitsgang begonnen wird.

Um nun dem Benutzer eines Werkzeugs eine Vorwarnung zu geben, daß der Akku in Kürze seine Auslösetemperatur erreicht hat, kann erfindungsgemäß vorgesehen sein, daß die Schalteinrichtung bei Erreichen der Auslösetemperatur vor dem Unterbrechen der Verbindung ein Signal abgibt, damit der Benutzer gewarnt wird.

Eine besonders günstige Möglichkeit, das Abschalten der Verbindung anzukündigen, besteht darin, daß die Schalteinrichtung bei Erreichen der Auslösetemperatur die Verbindung kurzzeitig unterbricht und anschließend wieder für eine gewisse Zeit einschaltet, bevor die Verbindung endgültig unterbrochen wird. Die erste kurzzeitige Unterbrechung kann eine so kurze Dauer aufweisen, daß der Benutzer gerade noch feststellen kann, daß eine Unterbrechung aufgetreten ist, also beispielsweise nur eine Sekunde betragen. Die Dauer der dann nochmaligen Einschaltung kann so bemessen werden, daß bei den erwähnten Beispielen ein Arbeitsvorgang gerade noch zu Ende geführt wird, also beispielsweise die Schraube vollständig eingedreht wird.

Eine weitere von der Erfindung vorgeschlagene Möglichkeit besteht darin, bei Erreichen der Auslösetemperatur mit der Unterbrechung der Verbindung so lange zu warten, bis die Stromabgabe des Akkumulators auf Null zurückgegangen ist, was ein Anzeichen dafür ist, daß der Benutzer das elektrische Gerät abgeschaltet hat. Dies würde also bedeuten, daß die Unterbrechung der Verbindung und damit das Abschalten des Akkus immer in einer Arbeitspause erfolgt.

Erfindungsgemäß kann vorgesehen sein, daß nach einer längeren Zeit von beispielsweise 1 bis 2 Minuten die Schaltung sich wieder in ihren Ausgangszustand zurücksetzt, damit nach dem Aufladen des Akkus die Vorgänge wieder von vorne ablaufen können.

Erfindungsgemäß kann vorgesehen sein, den die Verbindung unterbrechenden Schalter durch ein Leistungsdiode zu überbrükken, so daß auch bei geöffnetem Schalter ein sofortiges Laden möglich ist und bei einer größeren Hysterese des Schalters der Akku mit den normalen und möglicherweise bereits vorhandenen Ladegeräten wieder aufgeladen werden kann.

Da erfindungsgemäß bei dem Akkumulator nach Entnahme aus dem elektrischen Gerät unmittelbar anschließend mit der Ladung begonnen werden kann, schlägt die Erfindung in Weiterbildung ein für diesen Akku speziell geeignetes Ladegerät vor, das keine Temperaturabschaltung aufweist, die ein Laden des Akkus oberhalb der erwähnten Temperatur von etwa 45° C unmöglich macht. Es kann jedoch erfindungsgemäß vorgesehen sein, daß das Ladegerät eine Kühleinrichtung für den Akkumulator aufweist, so daß er sogar während des Ladens noch etwas auf die günstigste Temperatur abgekühlt werden kann. Zur Reduzierung der Zellentemperatur können im Akkugehäuse Lüftungsschlitze angebracht sein, die das Abkühlen weiter beschleunigen.

Erfindungsgemäß kann vorgesehen sein, daß das Ladegerät mit einem gepulsten Strom hoher Frequenz arbeitet, um hier die Temperaturbelastung niedrig zu halten.

Die Erfindung schafft also eine Möglichkeit, durch die Maßnahmen an dem Akku dafür zu sorgen, daß die Aufladezeiten mit Ladegeräten deutlich niedriger sind, so daß ein Benutzer eines elektrisch angetriebenen Gerätes mit zwei Akkus im Wechselbetrieb auskommen kann. Es ist nach der Erfindung weder ein Eingriff in dem elektrisch betriebenen Gerät erforderlich noch sind die bisherigen Ladegeräte unbrauchbar.

Weitere Merkmale, Einzelheiten und Vorzüge der Erfindung ergeben sich aus den Patentansprüchen, deren Wortlaut zum Inhalt der Beschreibung gemacht wird, der folgenden Beschreibung einer bevorzugten Ausführungsform der Erfindung sowie anhand der Zeichnung. Hierbei zeigen:
- Fig. 1: schematisch eine Handbohrmaschine mit einem Akku nach Erfindung;
- Fig. 2: ein Blockschaltbild einer möglichen Ausführungsform der Erfindung;
- Fig. 3: ein Blockschaltbild eines von der Erfindung vorgeschlagenen Ladegerätes.

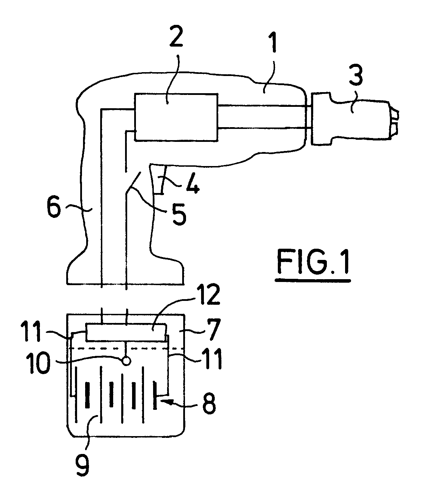

Als Beispiel für ein elektrisches Gerät, bei dem die Erfindung Anwendung finden kann, ist in Fig. 1 eine Handbohrmaschine 1 dargestellt, die einen Elektromotor 2 als Antriebsquelle aufweist. Der Elektromotor 2 treibt über ein Getriebe einen Drehantrieb mit einem Bohrfutter 3 an. Zum Ein- und Ausschalten des Elektromotors 2 dient eine Taste 4 an der Vorderseite des Griffs, die mechanisch mit einem elektrischen Schalter 5 verbunden ist. An der Unterseite des Handgriffs 6 ist eine Einrichtung zum Anstecken eines Akkupacks 7 vorgesehen, der den zum Antrieb des Elektromotors 2 nötigen Strom liefert. Der Akkupack enthält einen eigentlichen Akkumulator mit einer Reihe von Akkuzellen 9, die den Strom liefern. Die elektrische Verbindung zwischen dem Akkupack 7 und der Bohrmaschine geschieht mit Hilfe von Steckkupplungen, die in der Figur nur durch die Leitungen angedeutet sind. Die Steckkupplungen dienen auch dazu, den Akkupack 7 in ein Ladegerät einzusetzen und dort zu laden.

Der Akkupack 7 weist einen Temperaturfühler 10 auf, der so angeordnet ist, daß er die Temperatur der Zellen 9 des Akkus 8 erfassen kann. Die von den Zellen 9 wegführenden Leitungen 11 sind in eine beispielsweise elektronische Schaltung 12 geführt, die im Normalfall; d.h. bei niedrigerer Temperatur, die Anschlußdrähte 11 zu den Steckverbindungen durchschaltet. Sobald jedoch der Temperaturfühler 10 eine Temperatur meldet, die eine voreingestellte Auslösetemperatur überschreitet, so schaltet die Schaltung 12 die Spannung von mindestens einem der Steckanschlüsse ab. Der Elektromotor 2 erhält dann bei Erreichen dieser Temperatur auch dann keinen Strom mehr, wenn der Schalter 5 geschlossen wird.

Im einfachsten Fall, der nicht im einzelnen dargestellt ist, könnte als Temperaturfühler ein Bimetallelement vorgesehen` sein, das beispielsweise direkt mit einem Schalter verbunden ist, der die elektronische Schaltung 12 ersetzt.

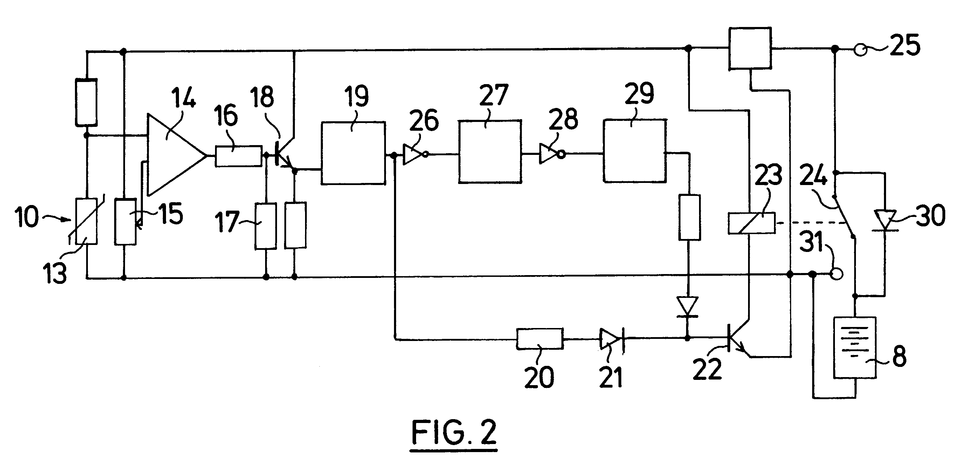

Fig. 2 zeigt nun ein bevorzugtes Ausführungsbeispiel der Erfindung, bei der die elektronische Schaltung 12 näher erläutert ist. Der Akku 8, um den es geht, ist rechts unten in Fig. 2 dargestellt. Der Temperaturfühler 10, der mit dem Akku 8 in thermischer Verbindung steht, ist aus Gründen der besseren Darstellung links in Fig. 2 gezeichnet. Er wird im dargestellten Ausführungsbeispiel von einen Widerstand 13 mit einem temperaturabhängigen Widerstandswert gebildet.

Der temperaturabhängige Widerstand 13 ist an einen Eingang eines als Komparators arbeitenden Operationsverstärkers 14 angelegt. An dem anderen Eingang des Operationsverstärkers 14 liegt eine Spannung an, die mit Hilfe eines Trimmerwiderstandes 15 eingestellt werden kann. Die Einstellmöglichkeit ist natürlich nicht für den Endverbraucher gegeben, sondern wird werksseitig vorgegeben, so daß der Trimmerwiderstand 15 auch durch zwei feste Widerstände ersetzt werden kann. Beispielsweise wird der Widerstandswert so eingestellt, daß er einem Temperaturwert von 58° Grad entspricht. Wird die dieser Temperatur entsprechende Spannungsschwelle überschritten, wird die Ausgangsspannung des Operationsverstärkers 14 positiv. Über einen Vorwiderstand 16 und einen Basiswiderstand 17 wird dann der Transistor 18 durchgeschaltet. Ein an den Emitter des Transistor 18 angeschlossener Multivibrator 19 erhält einen positiven Dauerimpuls, so daß sein Ausgang ebenfalls einen positiven Impuls liefert, dessen Länge durch die Werte des Multivibrators 19 festgelegt werden kann.

Einzelheiten des Multivibrators sind nicht dargestellt. Der positive Ausgangsimpuls des Multivibrators 19 liegt über einen Widerstand 20 und eine Diode 21 an dem zweiten Schalttransistor 22 und schaltet diesen durch. Dadurch wird das Relais 23 mit Strom versorgt, so daß es anzieht und den Schalter 24 öffnet. Die Verbindung zwischen dem Akku 8 und einer Ausgangsklemme 25 ist damit geöffnet.

Die Länge des Ausgangsimpulses des Multivibrators wird beispielsweise auf einige Sekunden festgesetzt. Nach dem Wegfall dieses Impulses schaltet der Schalter 24 also zurück, so daß an der Ausgangsklemme 25 wieder Spannung liegt.

Der Ausgang des Multivibrators 19 wird über einen Inverter 26 invertiert und einem zweiten Multivibrator 27 zugeführt. Dessen Ausgang erzeugt wieder einen Impuls, dessen Länge durch Daten des Multivibrators 27 festgelegt werden kann. Dieser Impuls wird wieder bei 28 invertiert und einem dritten Multivibrator 29 zugeführt. Dieser erzeugt wiederum einen positven Impuls, dessen Länge durch Daten des Multivibrators 29 festgelegt werden kann.

Bei dem ersten vom ersten Multivibrator 19 an den Transistor 22 gelangenden Impuls wird das Relais für die Dauer dieses Impulses eingeschaltet und der Akku abgeschaltet. Über die parallel zum Schalter 24 liegende Leistungsdiode 30 kann wegen ihrer Polarität kein Strom fließen. Nach einigen Sekunden fällt das Relais wieder ab, und der Akku liefert wiederum für einige Sekunden Strom, damit ein gerade begonnener Schraub- oder Bohrvorgang beendet werden kann. Die Dauer dieses Wiedereinschaltens wird durch die Daten des zweiten Multivibrators 27 festgelegt.

Nach diesem kurzen Wiedereinschalten wird dann mit Hilfe eines vom dritten Multivibrator bestimmten Impulses das Relais wieder endgültig eingeschaltet, so daß die Verbindung nunmehr endgültig unterbrochen ist. Der Akku liefert keinen Strom mehr.

Nach Ablauf dieses längeren Impulses, was beispielsweise nach 1 bis 2 Minuten geschieht, fällt das Relais wieder ab, so daß der ursprüngliche Zustand wieder hergestellt ist. Dies ist bei der dargestellten Schaltung erforderlich, damit sich die Schaltung wieder im Ausgangszustand befindet und beim nächsten Entladezyklus der geschilderte Vorgang wieder ablaufen kann.

Im abgeschalteten Zustand, wenn also der Akku beispielsweise eine Temperatur von 58° C aufweist, kann seine Ladung im Ladegerät sofort erfolgen, da auch bei geöffnetem Schalter 24 der Strom des Ladegeräts durch die Leistungsdiode 30 in den Akku fließen kann. Dies gilt selbstverständlich nur für den Fall, daß ein Ladegerät verwendet wird, das auch bei einer Temperatur von mehr als den üblichen 45° C aufladen kann. Beim Aufladen erfolgt zunächst aufgrund des Ladevorgangs eine gewisse Abkühlung, die durch ein im Ladegerät eingebautes Gebläse unterstützt und verstärkt werden kann. Der Ladezustand des Akkus kann im Ladegerät durch Ladeschlußspannung und Ladezeit überwacht werden, um eine Überladung mit ihren negativen Folgen zu vermeiden.

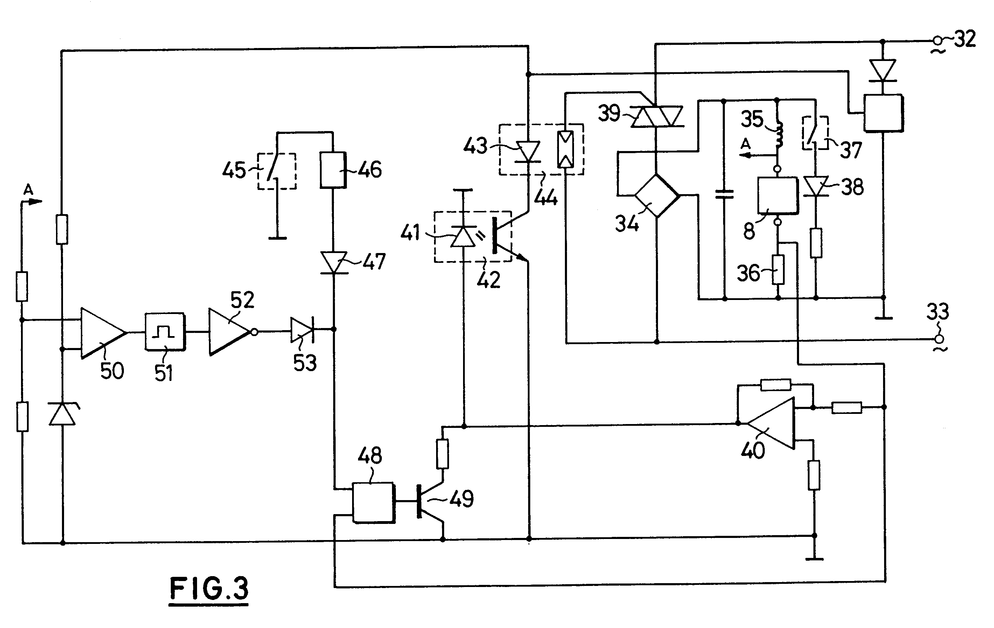

Fig. 3 zeigt ein Blockschaltbild eines von der Erfindung vorgeschlagenen Ladegerätes, das speziell auf den von der Erfindung vorgeschlagenen Akkupack angepaßt ist. Der Akkupack 7 mit dem darin enthaltenen Akku 8 wird in eine Fassung des Ladegeräts eingeschoben und die elektrische Verbindung mit den Klemmen des Akkus hergestellt. Das Ladegerät enthält einen in der Fig. 3 rechts oben dargestellten Ladeteil, an den Wechselspannung der gewünschten Größe angelegt wird. Diese Wechselspannung kann aus einem Transformatornetzteil oder einem Schaltnetzteil entnommen werden. Sie liegt an den Klemmen 32, 33 an. In einem Gleichrichter 34 wird die Wechselspannung in Gleichspannung umgewandelt und die Gleichspannung gesiebt. Über eine Spule 35 und einen Meßwiderstand 36 liegt die gesiebte Gleichspannung an dem Akkumulator 8 an. Das in der Spule 35 erzeugte Magnetfeld schaltet einen Reed-Schalter 37 ein, der eine Leuchtdiode 38 mit Strom versorgt. Damit wird der Ladevorgang angezeigt. Das Einschalten des Netzteils bzw. der Stromversorgung kann beispielsweise durch das Einstecken des Akkupacks in die Fassung des Ladegeräts ausgelöst werden.

Im Lastkreis liegt in Reihe mit dem Gleichrichter 34 ein Triac 39, der dazu dient, den Ladestrom durch den Akkumulator 8 zu regeln.

Am Meßwiderstand 36 wird eine von dem Strom durch den Akku 8 abhängige Spannung abgenommen und dem invertierenden Eingang eines Operationsverstärkers 40 zugeführt. Die vom Ausgang des Operationsverstärkers 40 abgegebene Spannung ist ebenfalls von dem durch den Meßwiderstand 36 fließenden Strom abhängig, allerdings phasengedreht. Die abgegebene Spannung sinkt bei höherem Stromfluß und steigt bei niedrigerem Stromfluß. Die Spannung wird an die Leuchtdiode 41 eines OPTO-Kopplers 42 angelegt. Sie steuert den lichtempfindlichen Transistor des OPTO-Kopplers 42 mehr oder weniger durch. In Reihe mit diesem Transistor liegt die Leuchtdiode 43 eines zweiten OPTO-Kopplers 44, die entweder einen Fotowiderstand oder einen lichtempfindlichen Feldeffekttransistor steuert, der im Gate-Kreis des Triacs 39 liegt. Je nach Durchsteuerung dieses Fotowiderstandes oder Feldeffekttransistors steuert der Gate-Kreis den Strom durch den Triac 39. Auf diese Weise wird der Ladestrom durch den Akku unabhängig von der Zellenzahl des zu ladenden Akkupacks geregelt. Da der Akku aufgrund seines Abschaltens vor seiner Tiefentladung mit einem höheren Ladestrom geladen werden kann, stellt das Gerät einen höheren Ladestrom als übliche Ladegeräte zur Verfügung. Um zu verhindern, daß in das Ladegerät ein herkömmlicher Akku eingesetzt werden kann, ist am Einschub des Ladegeräts eine erhabene Nase angebracht und weist der Akkupack an der gleichen Stelle einen Schlitz oder eine Vertiefung auf. Auf diese Weise lassen sich herkömmliche Akkupacks nicht in das Ladegerät einsetzen.

Die Überwachung des Ladevorgangs geschieht sowohl zeitabhängig als auch spannungsabhängig. Zu Beginn des Ladevorgangs wird entweder über einen im Akkupack enthaltenen Magneten oder durch das in der Spule 35 erzeugte Magnetfeld ein Reed-Schalter 45 geschlossen, der das Zeitglied 46 auslöst. Nach Ablauf der eingestellten Zeit gibt das Zeitglied 46 über die Diode 47 einen positiven Impuls an den einen Eingang eines bistabilen Multivibrators 48. Der Ausgang dieses Multivibrators steuert einen Schalttransistor 49, der die vom Ausgang des Operationsverstärkers 40 gelieferte Spannung kurzschließt und so mit Hilfe des Triacs 39 den Ladevorgang unterbricht. Die Einschaltung des Zeitglieds kann auch auf andere Weise erfolgen.

Der in Fig. 3 links zu sehende Komparator 50 überwacht die Ladeschlußspannung. Sobald diese Spannung erreicht ist, wird der monostabile Multivibrator 51 vom Ausgang des Komparators 50 gestartet und das durch den Inverter 52 invertierte Signal über eine Diode 53 an den Eingang des bistabilen Multivibrators 48 gegeben. Dieser beendet dann in der bereits beschriebenen Weise den Ladevorgang.

Der Ladevorgang wird also sowohl bei Auftreten der Ladeschlußspannung als auch bei Ablauf einer vorgegebenen Zeit beendet, je nachdem, welches Ereignis früher eintritt.

Der bistabile Multivibrator 48 wird durch einen Impuls zurückgesetzt, der entsteht, wenn das Akkupack aus dem Ladegerät entnommen wird.

Das Ladegerät kann einen Ventilator aufweisen, der temperaturgesteuert eingeschaltet wird und den Akku während des Ladens kühlt.

Zur Abschaltung des Ladestroms kann neben einem Triac 39 auch ein Relais, ein Transistor oder ein Thyristor verwendet werden.

## Patentansprüche

1. Akkupack für ein elektrisches Gerät (1), mit
1.1 zwei elektrischen Kontakten (25, 31)
1.2 einem Temperaturfühler (10) zum Abfühlen der Temperatur der Zellen (9) des Akkus (8),
1.3 einer Schalteinrichtung (12), die
1.3.1 mit dem Temperaturfühler (10) wirkverbunden ist und
1.3.2 bei Erreichen einer vorbestimmten Auslösetemperatur die Verbindung der Akkuzellen (9) mit einem Kontakt (25) unterbricht.

2. Akkupack nach Anspruch 1, bei dem die Schalteinrichtung (12) ein Bimetallelement, insbesondere einen Bimetallschalter aufweist.

3. Akkupack nach Anspruch 1 oder 2, mit einer elektronischen Schaltung (12), die einen Schalter (24) zum unterbrechen der Verbindung enthält und/oder ansteuert.

4. Akkupack nach Anspruch 3, bei dem der Schalter (24) von einem Relais (23, 24) gebildet ist.

5. Akkupack nach Anspruch 3, bei dem der Schalter (24) von einem Thyristor gebildet ist.

6. Akkupack nach Anspruch 3, bei dem der Schalter durch einen Transistor gebildet ist.

7. Akkupack nach Anspruch 3, bei dem der Schalter (24) von einem Triac gebildet ist.

8. Akkupack nach einem der vorhergehenden Ansprüche, bei dem die Schalteinrichtung (12) bei Erreichen der Auslösetemperatur ein Signal abgibt, bevor sie die Verbindung unterbricht.

9. Akkupack nach einem der vorhergehenden Ansprüche, bei dem die Schalteinrichtung derart ausgebildet ist, daß sie bei Erreichen der Auslösetemperatur erst dann die Verbindung unterbricht, wenn die Stromentnahme aus dem Akku (8) auf Null gesunken ist.

10. Akkupack nach einem der vorhergehenden Ansprüche, bei dem die Schalteinrichtung derart ausgebildet ist, daß sie bei Erreichen der Auslösetemperatur kurzzeitig die Verbindung unterbricht, danach wieder für kurze Zeit herstellt und anschließend wieder endgültig unterbricht.

11. Akkupack nach einem der vorhergehenden Ansprüche, bei dem nach einer bestimmten Zeit nach Unterbrechen der Verbindung die Schalteinrichtung wieder in ihren Ausgangszustand zurückgesetzt wird.

12. Akkupack nach einem der vorhergehenden Ansprüche, bei dem der die Verbindung unterbrechende Schalter (24) durch eine Leistungsdiode (30) überbrückt ist.

13. Ladegerät für einen aufladbaren Akku, insbesondere nach einem der vorhergehenden Ansprüche, mit
13.1 einer Spannungsversorgung,
13.2 einem Anschluß für den zu ladenden Akku, sowie
13.3 einer Kühleinrichtung zur Kühlung des Akkus.

14. Ladegerät nach Anspruch 13, bei dem die Spannungsversorgung mit einem gepulsten Strom hoher Frequenz arbeitet.

15. Ladegerät nach Anspruch 13, bei dem die Spannungsversorgung durch einen konstanten Ladestrom erfolgt.

16. Ladegerät nach einem der Ansprüche 13 bis 15, ohne Temperaturabschaltung.

17. Ladegerät nach einem der Ansprüche 13 bis 16, bei dem die Kühleinrichtung ein Kühlgebläse aufweist.
